# EUROPÄISCHE PATENTSCHRIFT

(11) **EP 2 040 527 B1**
(45) Veröffentlichungstag und Bekanntmachung des Hinweises auf die Patenterteilung: **19.04.2017**
(21) Anmeldenummer: 08105154.2
(22) Anmeldetag: 27.08.2008
(51) Int. Cl.: H05K 5/06

(54) **Elektronikgehäuse**
Electronics housing
Boîtier électronique

(30) Priorität: 21.09.2007 DE 102007045262
(43) Veröffentlichungstag der Anmeldung: 25.03.2009
(73) Patentinhaber: Continental Automotive GmbH, 30165 Hannover (DE)
(72) Erfinder: Loibl, Josef, 93077 Bad Abbach (DE); Robin, Hermann-Josef, 93053 Regensburg (DE)

(56) Entgegenhaltungen:
- EP-A- 1 737 286
- WO-A-92/20096
- WO-A-2008/128809

## Beschreibung

Die Erfindung betrifft ein Elektronikgehäuse gemäß dem Oberbegriff des Patentanspruchs 1, insbesondere für integrierte Getriebe- und Motorsteuerungen in der Automobilindustrie.

Elektronikgeräte weisen im Allgemeinen eine Vielzahl an elektronischen Komponenten auf, welche in Verbindung mit anderen Komponenten außerhalb des Steuergerätes stehen. Sie werden normalerweise in spezielle Gehäuse eingesetzt, um sie gegen Umwelteinflüsse oder mechanische Beanspruchungen zu schützen. Zudem erfüllen die Gehäuse eine wichtige Abschirmfunktion. Um eine verlässliche Verbindung zu außerhalb des Gehäuses liegenden Komponenten zu ermöglichen, ist eine elektrische Verbindung von der Gehäuseinnenseite zur Gehäuseaußenseite notwendig. Diese wird in jüngster Zeit bevorzugt als flexible Leiterplatte ausgeführt.

### Stand der Technik

Der Gehäusedeckel kann aus jedem Material bestehen, das einen ausreichenden Schutz der Elektronik gegenüber den gegebenen Umwelteinflüssen sicherstellt. Üblicherweise werden Gehäusedeckel aus Kunststoff verwendet, um die Elektronik-Komponenten zu verdeckeln. Alternativ kann auch ein metallisierter Kunststoff-Formkörper oder ein metallischer Gehäusedeckel eingesetzt werden. Um eine gute mechanische Stabilität zu gewährleisten und die geometrischen Vorgaben zum Bauraum zu erfüllen, weisen die Gehäuse im Allgemeinen recht komplexe Geometrien auf.

Bei Gehäusedeckeln aus Kunststoff ist es beispielsweise aus der WO 92/20096 A1 bekannt, durch eine Öffnung im Kunststoffdeckel eine Vergussmasse zum weiteren Schutz der Elektronik-Komponenten einzufüllen. Die Einfüllöffnungen werden dann durch Einpressen eines Stopfens, beispielsweise in Form von Kugeln oder Stiften, verschlossen. Nachteilig hierbei ist, dass erhebliche Einpresskräfte aufgebracht werden müssen, die eine starke Verformung des Deckels verursachen und den Vergussmassenverbund schädigen können. Umgekehrt sind auch verstärkte Materialien im Einsatz, die eine große Wandstärke aufweisen. Bei einem Kunststoffdeckel sind auch Verfahren bekannt, die Einfüllöffnung durch Aufschweißen eines Verschlusses zu verschließen. Dies ist ein zusätzlicher aufwendiger Herstellungsschritt, der nur schwer automatisierbar ist. Zusätzlich kann durch die Verschweißung ebenfalls eine Verformung des Gehäusedeckels hervorgerufen werden.
Ein zuverlässiger Verschluss eines metallischen Deckels ist noch schwerer zu realisieren, weil hier die Wandstärken in Abhängigkeit des Metalls umso größer sind und ein Verschwei-ßen höhere Temperaturen erfordert.
Ein solcher Verschluss ist jedoch unerlässlich zum Schutz der empfindlichen Elektronik-Komponenten, und insbesondere wenn die Elektronik-Komponenten aggressiven Medien ausgesetzt sind, wie sie beispielsweise in Getrieben und in Motoren bei integrierten Steuerungen vorherrschen.

Aus der EP 1 737 286 A2 ist alternativ ein versiegeltes E-lektronikmodul bekannt, in welchem eine Hauptleiterplatte und mindestens eine Hilfsleiterplatte in einem Gehäuse ohne Befestigungen angeordnet sind, die beide übereinander liegen.

Sie werden fixiert durch Aufbringen einer Vergussmasse auf die freiliegende Fläche der Hauptleiterplatte, welche durch ein oder mehrere Aussparungen in dieser Leiterplatte derart fließt, dass eine oder mehrere Brücken von Vergussmasse zwischen Hauptleiterplatte und der darunter liegenden Oberfläche der Hilfsleiterplatte gebildet werden.

### Aufgabenstellung

Aufgabe der Erfindung ist es daher, ein Elektronikgehäuse zur Verfügung zu stellen, das eine Einfüllöffnung für eine Vergussmasse aufweist, die auf einfache Weise, ohne die Gefahr einer Verformung, zuverlässig verschlossen werden kann.

Dies wird erfindungsgemäß mit einem Elektronikgehäuse entsprechend des Patentanspruchs 1 sowie mit einem Verfahren zur Herstellung eines solchen Elektronikgehäuses gemäß dem Patentanspruch 3 erreicht.

Erfindungsgemäß wird vorgeschlagen, ein Elektronikgehäuse mit einer Einfüllöffnung für eine Vergussmasse umfassend ein Gehäuseelement, eine Leiterplattenkomponente und eine Trägerkomponente mit elektronischen Bauteilen zur Verfügung zu stellen, in dem die Einfüllöffnung in der
Leiterplattenkomponente und/oder in der Trägerkomponente angeordnet ist und bei dem die Einfüllöffnung mittels Dichtlöten verschlossen ist.

Es können als Leiterplattenkomponenten erfindungsgemäß beispielsweise vergleichsweise kostengünstige PCB-Leiterplatten (Printed Circuit Bords) eingesetzt werden.

Gleichermaßen ist es möglich, als Leiterplattenkomponente mehrlagige flexible Leiterplatten einzusetzen. Die Leiterplattenkomponente ist bevorzugt zwei- oder mehrlagig. So kann bevorzugt eine zweilagige PCB-Leiterplatte mit einem elektrisch isolierenden Kern und einer Kupferbeschichtung eingesetzt werden.
Besonders bevorzugt wird eine doppelseitige PCB zur Signal- und Stromverteilung an beispielsweise Stecker, Sensoren oder Aktuatoren eingesetzt, die aus einem elektrisch isolierenden Kern und einer beidseitig aufgebrachten leitenden Beschichtung, bevorzugt aus Kupfer, aufgebaut ist. Zur Vermeidung von Kurzschlüssen können offene Leiterbahnbereiche durch einen Lötstopplack abgedeckt werden.
Dieser Aufbau ist relativ dünn und ermöglicht vorteilhafterweise die Ausbildung von dreidimensionalen Strukturen durch Biegen einzelner PCB-Bereiche. Dies ist für einen Einsatz beispielsweise in einem Getriebe sehr hilfreich, da unter anderem verschiedene Kontaktierlevel erforderlich sind. Gleichzeitig sind im Gegensatz zu einlagigen flexiblen Leiterplatten zudem Kreuzungen der Verteilungspfade möglich.

Weiterhin bevorzugt weist die mehrlagige Leiterplattenkomponente ihrerseits verschiedene Kontaktstellen zur elektronischen Anbindung der peripheren Komponenten auf. Wie vorstehend bereits beschrieben können sowohl Anschlüsse für Stecker als auch für Sensoren, Ventile und andere Aktuatoren vorgesehen werden, was eine große Flexibilität des Gesamtaufbaus des elektronischen Bauteils ermöglicht.
In einer bevorzugten Ausgestaltung kann die elektronische Anbindung der außerhalb des Gehäuses liegenden Komponenten mittels Einpresstechnik, Löten und/oder Laserschweißen ausgeführt werden.

Die Trägerkomponente kann einstückig oder mehrstückig ausgeführt sein.
Bevorzugt ist der Schaltunsgsträger erfindungsgemäß eine mehrlagige PCB Leiterplatte, wobei durch partielle Tiefenfräsung flexible Bereiche in den Randbereichen ausgebildet werden, die eine Biegung dieser Bereiche nach oben ermöglichen. So kann dort eine dreidimensionale Struktur gebildet werden, die eine Anpassung an den wannenförmigen Aufbau des Gehäusebodens erlaubt.
Die Tiefenfräsung kann mittels Laserabtrag oder Fräsen erfolgen. Sie kann den gesamten Randbereich der Trägerkomponente bis zu den Kanten umfassen. Gleichermaßen kann sie aber auch als Nut ausgebildet werden, so dass an den Anschlussbereichen der Kanten die PCB Leiterplatte in ursprünglicher Dicke verbleibt. Auf diese Weise ist die nötige Flexibilität zur Ausbildung der dreidimensionalen Strukturen gegeben, wobei gleichzeitig die Bearbeitungszeiten durch das Fräsen minimiert werden können.

In einer anderen bevorzugten Ausgestaltung der vorliegenden Erfindung können die elektronischen Bauteile der zentralen Steuerungselektronik in die mehrlagige PCB-Leiterplatte der Trägerkomponente innen liegend oder auf der Oberfläche integriert sein. Als elektronische Bauteile können beispielsweise gedruckte Widerstände oder Kapazitäten, die auch als Leitungen oder Flächen ausgeführt sein können, sowie Chips oder komplexe Chips (ICs) eingesetzt werden. Auch die Verarbeitung von so genannten Bare-Chips, die gebondet werden, und von gehäusten Bauelementen, die geklebt oder gelötet werden, ist möglich. Auf diese Weise sind eine erhöhte Langzeitstabilität und eine ausgezeichnete Anbindung an die Signal- und Potentialverteilungspfade der Trägerkomponente gewährleistet.

Die elektronischen Bauteile der zentralen Steuerungselektronik können bevorzugt mittels Lötverfahren oder Kleben auf der mehrlagigen Leiterplatte befestigt und/oder kontaktiert sein. Das Lötverfahren kann beispielsweise ein Reflow-Lötverfahren sein.

Durch die Einfüllöffnung kann eine Vergussmasse eingefüllt werden, die den Schutz der empfindlichen Elektronik-Komponenten vor mechanischen und chemischen Belastungen, wie zum Beispiel Vibration, Feuchtigkeit, Schmutz und Korrosion nochmals deutlich verbessern können. Außerdem kann durch den Verguss zusätzlich eine Spannungsisolation der Elektronik erreicht werden. Die Einfüllöffnung bietet weiterhin die Möglichkeit, das Gehäuse zu evakuieren und dadurch die Blasenfreiheit die Vergussmasse sicherzustellen sowie anschließend oder gleichzeitig das Elektronikgehäuse auf Dichtheit zu überprüfen.

Die Einfüllöffnung kann bevorzugt mittels Fräsen, Laserschneiden, Bohren oder Stanzen in die als Leiterplattenkomponente und/oder als Trägerkomponente eingesetzten PCB (Printed Circuit Board) eingebracht werden.

Damit kann die notwendige Dichtheit des Elektronikgehäuses auf einfache Weise ohne die Gefahr einer Verformung des Gehäusedeckels hergestellt werden.

Der Prozess ist automatisierbar, kostengünstig und daher auch für die Massenproduktion geeignet. Ein aufwendiges Schweißverfahren zum Verschließen der Einfüllöffnung ist nicht mehr notwendig. Die erfindungsgemäß verschlossenen Elektronikgehäuse können auch in aggressiven Umgebungsbedingungen, wie beispielsweise in einem Kraftfahrzeuggetriebe, eingesetzt werden und einen zuverlässigen Verschluss der Einfüllöffnung und somit den Schutz der Elektronik-Komponenten im Gehäuseinneren sicherstellen.

Das Gehäuseelement besteht bevorzugter Weise aus einem Stanzbiegeteil aus einem metallischen Material, besonders bevorzugt ist es aus Aluminium. Es kann in verschiedener Weise als Gehäusedeckel oder als Gehäuseboden in Form einer Bodenwanne ausgestaltet sein.

In einer bevorzugten Ausführungsform der Erfindung wird die Trägerkomponente in die metallische Bodenwanne eingesetzt und mit einem Wärmeleitkleber fest und temperaturoptimiert verklebt. Die Leiterplattenkomponente wird in dieser Ausgestaltung darüber angeordnet und dient somit als Deckel. Dies stellt neben einer guten Wärmeableitung eine verlässliche und kostengünstige Fixierung sicher. Zudem wird auf diese Weise eine Abdichtung des Elektronikraums nach unten beispielsweise zum Getriebeöl hin erreicht.

Besonders bevorzugt können an den Randbereichen des wannenförmigen Gehäusebodens Noppen oder andere Befestigungselemente ausgeprägt sein, die einen definierten Sitz des Schaltungsträgers sicherstellen.

Weitere vorteilhafte Ausgestaltungen und Weiterbildungen, welche einzeln oder in Kombination miteinander eingesetzt werden können, sind Gegenstand der abhängigen Ansprüche.

Bevorzugt besteht das Gehäuseelement aus einem metallischen Material und ist beispielsweise als Stanzbiegeteil aus Stahlblech, Aluminium gefertigt. Dadurch ergeben sich eine erhöhte Steifigkeit und Langzeitstabilität, eine gute Diffusionsdichte gegenüber aggressiven Chemikalien und verbesserte EMV-Abschirmwerte über die gesamte Lebensdauer des Steuergeräts. Im Gegensatz zu den bisher eingesetzten Gehäusedeckeln mit dort angeordneter Einfüllöffnung zur Dichtheitsprüfung und für die Vergussmassen kann der Gehäusedeckel des erfindungsgemäßen Elektronikgehäuses mit verringerter Wandstärke beziehungsweise mit einfacherer Geometrie gefertigt werden. Dadurch kann eine erhebliche Kostenreduktion erzielt werden.

In einer bevorzugten Ausgestaltung der Erfindung kann die Einfüllöffnung eine einfache Geometrie aufweisen. Dadurch kann eine gute Stabilität der als Trägerkomponente oder Leiterplattenkomponente eingesetzten Leiterplatte bei gleichzeitiger guter Toleranzkontrolle sicher gestellt werden.

In einer weiteren Ausführungsform der Erfindung kann die Einfüllöffnung mindestens teilweise metallisiert, bevorzugt verkupfert, sein. Auf diese Weise wird für ein nachfolgendes Verschließen mittels Löten eine gute Haftung des Lötmaterials an der Abdichtungsstelle gewährleistet. Zudem kann damit ein verbesserter Kantenschutz für die Ränder der Einfüllöffnung erzielt werden.

Hierdurch wird ein langzeitstabiler zuverlässiger Verschluss des Gehäusedeckels auch über die gesamte Lebensdauer eines Kraftfahrzeuggetriebes gewährleistet.

Eine integrierte elektronische Schaltung in Kraftfahrzeugen ist beispielsweise einer aggressiven Umgebung im Getriebeöl ausgesetzt. Im Betrieb und in der Lagerung ist sie sehr hohen und sehr niedrigen Temperaturen, im Bereich von -40 °C bis + 180 °C, sowie hohen Vibrationen ausgesetzt. Erfindungsgemäß können als Vergussmasse beispielsweise Harze, Polyurethanmassen oder Silikone eingesetzt werden. Diese Vergussmassen können die Elektronik-Komponenten vorteilhaft gegen die genannten mechanischen und/oder chemischen Beanspruchungen schützen.

Besonders bevorzugt werden erfindungsgemäß Silikongele eingesetzt. Silikongele können zusätzlich zu den weiteren Vorteilen eine besonders einfache Verarbeitung ermöglichen und durch ein niedriges E-Modul thermomechanische Spannungen verhindern.

Zur Herstellung eines erfindungsgemäßen Elektronikgehäuses kann ein Verfahren mit den nachfolgenden Schritten ausgeführt werden:
- Einbringen einer Einfüllöffnung in eine Trägerkomponente mit elektronischen Bauteilen und/oder in eine
   Leiterplattenkomponente,
- Verbinden einer Trägerkomponente mit elektronischen Bauteilen und einer Leiterplattenkomponente,
- Fixieren eines Gehäuseelements an der Leiterplattenkomponente,
- Einfüllen von Vergussmasse durch die Einfüllöffnung, und
- dicht Verschließen der Einfüllöffnung durch Dichtlöten.

Durch die Vergussmassen kann ein Elektronik-Substrat mit den elektronischen Komponenten noch besser vor mechanischen und/oder chemischen Belastungen geschützt werden.

Vorteilhafterweise kann das Verschließen der Einfüllöffnung ohne die Gefahr einer Verformung des Gehäusedeckels oder des Trägerelements automatisiert erfolgen.

In einer anderen Ausführungsform des Verfahrens kann das Gehäuse mit den vergossenen Elektronik-Komponenten durch die Einfüllöffnung vorteilhafterweise vor dem Verschluss durch Dichtlöten evakuiert werden. Zum einen kann dadurch die Blasenfreiheit der Vergussmasse sichergestellt werden, zum anderen kann gleichzeitig oder anschließend die Dichtheit des Gehäuses überprüft werden. So kann eine Dichtheitsprüfung durch die Einfüllöffnung vor dem Verschluss durch Dichtlöten vorgenommen werden. Dies ermöglicht daher außerdem eine einfache Qualitätskontrolle. Nach einer solchen Qualitätskontrolle kann ein beschrifteter Aufkleber, beispielsweise mit Qualitätssiegel oder Typenbezeichnung, auf die Einfüllöffnung aufgebracht werden.

Die Erfindung wird nachfolgend in beispielhafter Weise anhand von zwei Ausführungsvarianten in Verbindung mit den Zeichnungen erläutert. Sie ist jedoch nicht hierauf beschränkt.

In diesen zeigt:
**Fig. 1** eine schematische Querschnittsansicht eines erfindungsgemäßen Elektronikgehäuses mit Gehäusedeckel und Einfüllöffnung in der Trägerkomponente;
**Fig. 2** eine schematische Querschnittsansicht eines erfindungsgemäßen Elektronikgehäuses mit wannenförmigem Gehäuseboden und Einfüllöffnung in der Leiterplattenkomponente.

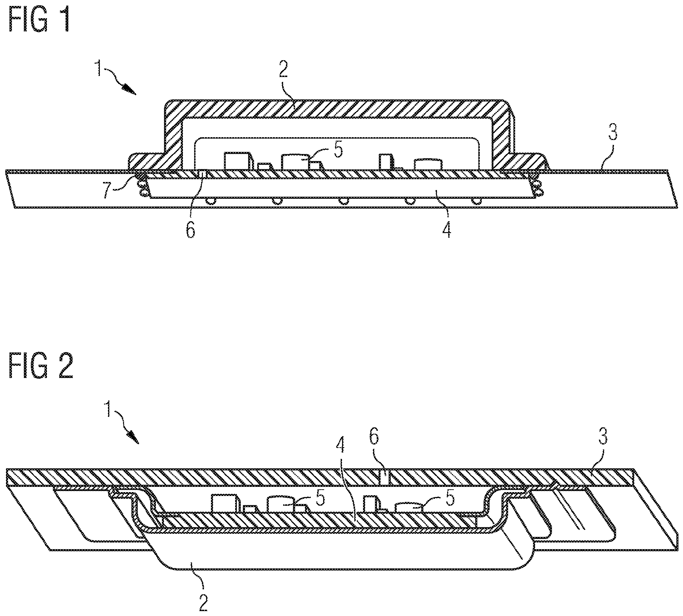

**Fig. 1** zeigt ein Elektronikgehäuse **1** für ein Elektronikgerät, das zum Einbau in ein Kraftfahrzeuggetriebe vorgesehen ist. Das Gehäuse **1** wird von einer Leiterplattenkomponente **3** und einem metallischen Gehäusedeckel **2**, der bevorzugt als Stanzbiegeteil aus Stahlblech oder Aluminium geformt sein kann, gebildet. Die Leiterplattenkomponente **3** ist bevorzugt aus einer mehrlagigen Leiterplatte mit einem isolierenden Kern und ein oder zwei darauf beschichtete Kupferlagen gebildet. Sie weist Kontaktstellen zur Anbindung von peripheren Komponenten auf und ist weiterhin mit der Trägerkomponente **4** über Bond-Verbindungen **7** elektrisch verbunden. Gleichermaßen können die Verbindungen mittels Klebe- oder Lötverbindungen ausgeführt sein. Die Trägerkomponente **4** kann bevorzugt ebenfalls als mehrlagige Leiterplatte mit einem isolierenden Kern und ein oder zwei Kupferbeschichtungen ausgeführt sein und weist an ihrer Oberfläche elektronische Bauteile **5** auf, welche gleichermaßen als integrierte Bauteile innen liegend ausgeführt sein können. Der Gehäusedeckel überragt mit seiner Aufsatzfläche die verbundenen Randbereiche der Leiterplattenkomponente **3** und des Trägerelements **4**, so dass eine zusätzliche mechanische Verbindung über die Fixierung der Aufsatzfläche des Gehäusedeckels zwischen den drei Bauteilen erreicht wird. Erfindungsgemäß ist eine Einfüllöffnung **6** in der Trägerkomponente **4** vorgesehen, durch die eine Vergussmasse in den abgedichteten Elektronikraum eingefüllt werden kann. Die Einfüllöffnung **6** kann teilweise, wie zum Beispiel an ihren Kanten, oder vollständig metallisiert, bevorzugt verkupfert, sein. Sie weist vorzugsweise eine einfache Geometrie auf, um eine Destabilisierung der Leiterplatte der Trägerkomponente zu verhindern. Die Vergussmasse kann vorzugsweise ein Silikongel sein.

Durch die Einfüllöffnung **6** kann das Gehäuse **1** zusätzlich evakuiert werden. Durch die Evakuierung kann die Blasenfreiheit der Vergussmasse sichergestellt werden. Außerdem kann gleichzeitig oder anschließend die Dichtheit des Gehäuses **1** überprüft werden. Die Einfüllöffnung kann anschließend erfindungsgemäß bevorzugt mittels Dichtlöten verschlossen werden.

**Fig. 2** zeigt eine weitere Ausgestaltung des erfindungsgemäßen Elektronikgehäuses **1** mit einem wannenförmig ausgeformten Gehäuseboden **2** und darauf aufgebrachter Trägerkomponente **4**. Die Trägerkomponente **4** bestückt mit den elektronischen Bauteilen **5** der zentralen Steuerungselektronik ist in ihren Randbereichen nach oben gebogen, so dass eine flächige Anlage zu der darüber angeordneten Leiterplattenkomponente **3** entsteht. Der wannenförmige Gehäuseboden **2** ist bevorzugt ein Stanzbiegeteil aus Aluminium und nimmt die Trägerkomponente **4** vollständig auf. In seinen Randbereichen ist der wannenförmige Gehäuseboden an der darüber angeordneten
Leiterplattenkomponente **3** befestigt. Die Befestigung kann bevorzugt mittels Laminierung erfolgen. Zusätzlich können auch weitere mechanische Befestigungen wie Nasen, Noppen, Schrauben oder Nieten vorgesehen sein. Der wannenförmige Gehäuseboden **2** fungiert gleichzeitig als Wärmesenke für die darin angeordnete Trägerkomponente **4**, die daher bevorzugt mittels Wärmeleitkleber an dem Gehäuseboden befestigt ist.

Erfindungsgemäß weist die Leiterplattenkomponente **3** eine Einfüllöffnung **6** für Vergussmassen auf. Wie vorstehend für die Ausführungsform der Fig. 1 bereits beschrieben, kann die Einfüllöffnung **6** teilweise, wie zum Beispiel an ihren Kanten, oder vollständig metallisiert, bevorzugt verkupfert, sein. Sie weist vorzugsweise eine einfache Geometrie auf, um eine Destabilisierung der Leiterplatte der Trägerkomponente zu verhindern. Die Vergussmasse kann vorzugsweise ein Silikongel sein.

Durch die Einfüllöffnung **6** kann das Gehäuse **1** zusätzlich evakuiert werden. Durch die Evakuierung kann auch hier die Blasenfreiheit der Vergussmasse sichergestellt werden. Außerdem kann gleichzeitig oder anschließend die Dichtheit des Gehäuses **1** überprüft werden. Die Einfüllöffnung kann ebenfalls anschließend erfindungsgemäß bevorzugt mittels Dichtlöten verschlossen werden.

Zusammenfassend kann demnach erfindungsgemäß ein Elektronikgehäuse bereitgestellt werden, das eine Trägerkomponente und/oder eine Leiterplattenkomponente mit einer Einfüllöffnung für eine Vergussmasse aufweist, die auf einfache Weise und ohne die Gefahr einer Verformung des Gehäusedeckels zuverlässig verschlossen werden kann. Der erfindungsgemäße Verschluss der Einfüllöffnung mittels Dichtlötens kann dabei vorteilhafterweise automatisiert erfolgen und kann auch in aggressiven Umgebungsbedingungen, beispielsweise in Kraftfahrzeuggetrieben eingesetzt werden.

## Patentansprüche

1. Elektronikgehäuse (1) mit einer Einfüllöffnung (6) für eine Vergussmasse umfassend ein Gehäuseelement (2), eine Leiterplattenkomponente (3) und eine Trägerkomponente (4) mit elektronischen Bauteilen (5), wobei die Einfüllöffnung (6) in der Leiterplattenkomponente (3) und/oder in der Trägerkomponente (4) angeordnet ist **dadurch gekennzeichnet, dass** die Einfüllöffnung mittels Dichtlöten verschlossen ist.

2. Elektronikgehäuse (1) nach Anspruch 1, **dadurch gekennzeichnet, dass** die Einfüllöffnung (6) mindestens teilweise metallisiert, bevorzugt verkupfert, ist.

3. Verfahren zur Herstellung eines Elektronikgehäuses (1) mit den Merkmalen mindestens eines der vorhergehenden Ansprüche, **gekennzeichnet durch** die Schritte:
- Einbringen einer Einfüllöffnung in eine Trägerkomponente (4) mit elektronischen Bauteilen und/oder in eine
Leiterplattenkomponente (3),
- Verbinden einer Trägerkomponente (4) mit elektronischen Bauteilen und einer Leiterplattenkomponente (3),
- Fixieren eines Gehäuseelements (2) an der
Leiterplattenkomponente (3),
- Einfüllen von Vergussmasse **durch** die Einfüllöffnung (6), und
- Verschließen der Einfüllöffnung (6),
**dadurch** gekennzeichnet, dass das Elektronikgehäuse nach dem Einfüllen der Vergussmasse **durch** die Einfüllöffnung **durch** Dichtlöten dicht verschlossen wird.

4. Verfahren nach Anspruch 3, **dadurch gekennzeichnet, dass** als Vergussmasse Harze, Polyurethanmassen oder Silikone, bevorzugt ein oder mehrere Silicongele, eingesetzt werden.

5. Verfahren nach Anspruch 3 oder 4 **dadurch gekennzeichnet, dass** die Einfüllöffnung mindestens teilweise metallisiert, bevorzugt verkupfert, wird.

6. Verfahren nach einem der Ansprüche 3 bis 5, **dadurch gekennzeichnet, dass** das Elektronikgehäuse (1) nach dem Einfüllen der Vergussmasse durch die Einfüllöffnung (6) und vor dem Verschluss durch Dichtlöten evakuiert wird.

7. Verfahren nach einem der Ansprüche 3 bis 6, **dadurch gekennzeichnet, dass** eine Dichtheitsprüfung durch die Einfüllöffnung (6) vor dem Verschluss durch Dichtlöten vorgenommen wird.

8. Verwendung eines Elektronikgehäuses (1) nach einem der Ansprüche 1 oder 2 für ein elektronisches Steuergerät, bevorzugt für eine integrierte Getriebe- oder Motorsteuerung eines Kraftfahrzeugs.

## Claims

1. Electronics housing (1) with a filling opening (6) for a potting compound, comprising a housing element (2), a printed circuit board component (3) and a carrier component (4) with electronic devices (5), wherein the filling opening (6) is arranged in the printed circuit board component (3) and/or in the carrier component (4), **characterized in that** the filling opening is closed by means of sealing soldering.

2. Electronics housing (1) according to Claim 1, **characterized in that** the filling opening (6) is at least partially metallized, preferably copperized.

3. Method for producing an electronics housing (1) with the features of at least one of the preceding claims, **characterized by** the steps of:
- making a filling opening in a carrier component (4) with electronic devices and/or in a printed circuit board component (3),
- connecting a carrier component (4) with electronic devices and a printed circuit board component (3),
- fixing a housing element (2) on the printed circuit board component (3),
- introducing potting compound through the filling opening (6), and
- closing the filling opening (6),
**characterized in that**, after introducing the potting compound through the filling opening, the electronics housing is closed in a sealed manner by sealing soldering.

4. Method according to Claim 3, **characterized in that** resins, polyurethane compounds or silicones, preferably one or more silicone gels, are used as the potting compound.

5. Method according to Claim 3 or 4, **characterized in that** the filling opening is at least partially metallized, preferably copperized.

6. Method according to one of Claims 3 to 5, **characterized in that**, after introducing the potting compound through the filling opening (6) and before closing by sealing soldering, the electronics housing (1) is evacuated.

7. Method according to one of Claims 3 to 6, **characterized in that** a tightness test is performed through the filling opening (6) before the closing by sealing soldering.

8. Use of an electronics housing (1) according to either of Claims 1 and 2 for an electronic control device, preferably for an integrated transmission or engine control of a motor vehicle.

## Revendications

1. Boitier électronique (1) comportant une ouverture de remplissage (6) destinée à une masse de scellement, comprenant un élément de boîtier (2), un composant de carte de circuit imprimé (3) et un composant de support (4) muni de composants électroniques (5), dans lequel l'ouverture de remplissage (6) est disposée dans le composant de carte de circuit imprimé (3) et/ou dans le composant de support (4),
**caractérisé en ce que** l'ouverture de remplissage est fermée au moyen d'un brasage d'étanchéité.

2. Boîtier électronique (1) selon la revendication 1, **caractérisé en ce que** l'ouverture de remplissage (6) est au moins partiellement métallisée, et est de préférence cuivrée.

3. Procédé de fabrication d'un boîtier électronique présentant les caractéristiques d'au moins l'une des revendications précédentes, **caractérisé par** les étapes consistant à :
- créer une ouverture de remplissage dans un composant de support (4) muni de composants électroniques et/ou dans un composant de carte de circuit imprimé (3),
- relier un composant de support (4) à des composants électroniques et à un composant de carte de circuit imprimé (3),
- fixer un élément de boîtier (2) au composant de carte de circuit imprimé (3),
- introduire une masse de scellement à travers l'ouverture de remplissage (6), et
- refermer l'ouverture de remplissage (6),
**caractérisé en ce que** le boîtier électronique est refermé de manière étanche par brasage d'étanchéité après l'introduction de la masse de scellement à travers l'ouverture de remplissage.

4. Procédé selon la revendication 3, **caractérisé en ce qu'**on utilise en tant que masse de scellement des résines, des masses de polyuréthane ou de la silicone, de préférence un plusieurs gels de silicium.

5. Procédé selon la revendication 3 ou 4, **caractérisé en ce que** l'ouverture de remplissage est au moins partiellement métallisée, et est de préférence cuivrée.

6. Procédé selon l'une quelconque des revendications 3 à 5, **caractérisé en ce que** le boîtier électronique est mis sous vide après l'introduction de la masse de scellement à travers l'ouverture de remplissage (6) et avant la fermeture par brasage d'étanchéité.

7. Procédé selon l'une quelconque des revendications 3 à 6, **caractérisé en ce qu'**un test d'étanchéité est effectué à travers l'ouverture de remplissage (6) avant la fermeture par brasage d'étanchéité.

8. Utilisation d'un boîtier électronique (1) selon l'une quelconque des revendications 1 ou 2 pour un appareil de commande électronique, de préférence pour une unité de commande de transmission ou de moteur intégrée d'un véhicule automobile.
